# EUROPÄISCHE PATENTSCHRIFT

(11) **EP 1 290 784 B1**
(45) Veröffentlichungstag und Bekanntmachung des Hinweises auf die Patenterteilung: **30.07.2008**
(21) Anmeldenummer: 01955187.8
(22) Anmeldetag: 05.06.2001
(51) Int. Cl.: H03D 1/10

(54) **DEMODULATIONSSCHALTUNG UND DEMODULATIONSVERFAHREN**
DEMODULATION CIRCUIT AND DEMODULATION METHOD
CIRCUIT ET PROCEDE DE DEMODULATION

(30) Priorität: 14.06.2000 DE 10029271
(43) Veröffentlichungstag der Anmeldung: 12.03.2003
(73) Patentinhaber: Infineon Technologies AG, 81669 München (DE)
(72) Erfinder: KARGL, Walter, 8020 Graz (AT); KUPNIK, Mario, 8700 Leoben (AT); NEUHOLD, Ernst, A-8071 Hausmannstätt (AT)
(74) Vertreter: Epping - Hermann - Fischer
(86) Internationale Anmeldenummer: PCT/DE2001/002100
(87) Internationale Veröffentlichungsnummer: WO 2001/097372

(56) Entgegenhaltungen:
- EP-A- 0 524 008
- US-A- 3 895 298
- US-A- 4 706 262
- US-A- 4 737 730
- US-A- 4 853 643

## Beschreibung

Die vorliegende Erfindung betrifft eine Schaltungsanordnung und ein Verfahren zur Demodulation eines amplitudenmodulierten (AM-) Signals.

In bekannter Weise wird bei einer Amplitudenmodulation die Amplitude einer Sinusschwingung, welche eine Trägerfrequenz hat, zur Übermittlung von Informationen moduliert. In einem Demodulator wird eine Änderung der Amplitude des modulierten Signals erfaßt und ausgewertet.

Aufgrund der immer größeren, zu bewältigenden Datenmengen in der Kommunikationstechnik besteht der Trend zu immer höheren Übertragungsfrequenzen. Modulatoren und Demodulatoren-müssen den Anforderungen an die immer höheren Frequenzen gerecht werden können. Dabei müssen die Schaltungen zur Modulation und Demodulation eines amplitudenmodulierten Signals für verschiedene Tastverhältnisse funktionieren. Das Tastverhältnis eines Rechtecksignals ist der Quotient aus der Zeitdauer von ansteigender bis abfallender Flanke und Zeitdauer von ansteigender bis zur nächsten ansteigenden Flanke.

Ein einfach aufgebauter, bekannter Spitzenwert-Gleichrichter weist eine in Durchlaßrichtung geschaltete Diode auf, an deren Eingang ein zu demodulierendes, amplitudenmoduliertes Signal zuführbar ist, und an deren Ausgang ein Kondensator C parallel zu einem Widerstand R gegen Maße geschaltet ist. Bei geeigneter Wahl der Zeitkonstante τ, mit τ = R x C, liegt über Kondensator C beziehungsweise Widerstand R das gewünschte, demodulierte Signal an. Bei einer digitalen Amplitudenmodulation ist dieses Signal üblicherweise ein Rechtecksignal. Das Tastverhältnis dieses Rechtecksignals ist nicht a priori bekannt, da es von der zu übertragenden Information abhängt. Die Zeitkonstante τ beeinflußt dabei die Entladezeit des Kondensators C. Zur Demodulation eines amplitudenmodulierten Signals mit einer Trägerfrequenz im Bereich von einigen 10 Megahertz ist die beschriebene Spitzenwert-Gleichrichtung ungeeignet, da eine Dimensionierung der Schaltung, insbesondere das Einstellen einer geeigneten Zeitkonstante τ, derart, daß die Schaltung für die verschiedensten Tastverhältnisse funktioniert, praktischerweise nahezu unmöglich scheint. Denn wenn τ zu groß eingestellt ist, entsteht am Ausgang des Demodulators keine signifikante Spannungsänderung. Wählt man hingegen τ zu klein, folgt das Ausgangssignal zwar dem Modulationssignal, wird aber in nachteilhafter Weise von einer hochfrequenten Schwingung überlagert. Dies macht eine einfache Auswertung des Signals unmöglich, da es bei einem Vergleich des Modulationssignals mit einer Referenzspannung zur Detektierung von High- beziehungsweise Low-Zuständen keine eindeutigen Schnittpunkte bei einem Pegelwechsel gibt.

Das Dokument US 3,895,298 zeigt eine Anordnung, in der Amplitudenwerte eines demodulierten Signals, das aus einer Demodulation eines amplitudenmodulierten Signals resultiert, über einen Komparator miteinander verglichen werden. Aus dem Vergleich wird ein Steuersignal erzeugt, das zur Anpassung eines Trägersignals verwendet wird, um ein Verhältnis positiver und negativer Spitzenwerte des demodulierten Signals aneinander anzugleichen.

Der vorliegenden Erfindung liegt die Aufgabe zugrunde, eine einfach aufgebaute Demodulationsschaltung sowie ein einfaches Demodulationsverfahren anzugeben, welche jeweils für hohe Frequenzen geeignet sind.

Diese Aufgabe wird mit den Gegenständen der unabhängigen Patentansprüche gelöst.

Der Schaltungsanordnung liegt das übergeordnete Prinzip zugrunde, daß eine Spitzenwert-Gleichrichtung mittels schaltbarer Zeitkonstanten angegeben ist.

Die vorliegende Schaltungsanordnung weist eine erste Diode auf, der ein Kondensator gegen Masse nachgeschaltet ist, wobei der Kondensator mittels eines Schalters entladen werden kann. Wenn der ersten Diode beispielsweise ein sinusförmiges Signal zugeführt wird, so wirkt die Diode in der Weise als Schalter, daß jeweils nur die positiven Halbwellen durchgelassen und somit dem Kondensator zugeführt werden. Hierdurch wird der Kondensator jeweils auf den Spitzenwert der positiven Halbwelle aufgeladen. Um auch die Spitzenwerte nachfolgender Halbwellen erfassen zu können, kann mit der ersten Entladevorrichtung, welche ein Schalter sein kann, und welche parallel zum ersten Kondensator angeordnet ist, der Kondensator entladen werden. Somit kann der Spitzenwert einer Halbwelle auch dann zuverlässig ermittelt werden, wenn dieser Spitzenwert geringer als der einer vorangehenden Halbwelle ist. Der Schalter kann zur Entladung der Kapazität während der Sperrphase der Diode geschlossen werden. Zwischen der Aufladung des Kondensators auf einen Spannungswert, welcher dem Spitzenwert einer Halbwelle entspricht, und dem Entladen des Kondensators mit dem Schalter kann die am Kondensator anliegende Spannung ausgewertet werden.

Gegenüber einem herkömmlichen Spitzenwert-Gleichrichter mit einem Widerstand, über den der Kondensator entladbar ist, weist die vorliegende Anordnung das vorteilhafte Grundprinzip auf, daß zwischen Zeitkonstanten umgeschaltet werden kann. Hierfür ist der Schalter, welcher parallel zum Kondensator angeordnet ist, sowie die Diode, welche in Zusammenhang mit einer AC-(Wechsel-)Eingangsspannung als impliziter Schalter wirkt, vorgesehen.

Das beschriebene Prinzip einer Demodulationsschaltung beziehungsweise eines Demodulationsverfahrens hat den Vorteil, daß es einfach und mit geringem Aufwand realisierbar und für hohe Frequenzen geeignet ist.

Weiterhin ist ein zweiter Kondensator vorgesehen, dem das gleichgerichtete Signal zuführbar ist, über dem eine Spannung abgreifbar ist und der mit einem Anschluß nach Masse geschaltet ist, eine zweite Entladevorrichtung, welche parallel zu dem zweiten Kondensator geschaltet ist, und eine Auswerteeinheit zum Vergleich der Spannungen am ersten und zweiten Kondensator, an welcher ein demoduliertes Signal abgreifbar ist.

Dieser Demodulationsschaltung liegt.das Prinzip zugrunde, zwei Kondensatoren zu verwenden, welche jeweils eine Entladevorrichtung zum Entladen des Kondensators aufweisen, und denen jeweils das zu demodulierende Signal zuführbar ist. Den Kondensatoren ist dabei eine Diode vorgeschaltet. Die Polarität der Diode hängt dabei von der Polarität der verwendeten Kondensatoren ab. Die dem ersten und zweiten Kondensator parallel geschalteten Schalter sind so anzusteuern, daß ein Vergleich eines Amplitudenwertes des modulierten Signals mit einem vorhergehenden Amplitudenwert in einer Auswerteeinheit möglich ist.

In den beiden Kondensatoren können aufeinanderfolgende Halbwellen des zu demodulierenden Signals abwechselnd gespeichert werden, so daß jeweils ein Vergleich aufeinanderfolgender Halbwellen durch Vergleich der durch die Halbwellen eingeprägten Kondensatorspannungen ermöglicht ist. Wenn jedoch bei sehr hohen Frequenzen eine präzise Detektierung von Pegeländerungen zwischen zwei aufeinanderfolgenden Halbwellen nicht mit hinreichender Genauigkeit möglich ist, kann beispielsweise nur jede zweite, dritte, vierte, und so weiter Halbwelle verglichen werden. Hierbei wird in einem ersten Kondensator beispielsweise eine Amplitude einer bestimmten Halbwelle gespeichert, und in einem zweiten Kondensator wird nicht die unmittelbar darauffolgende Halbwelle, sondern beispielsweise die übernächste oder dritte folgende Halbwelle gespeichert. Zwischen den nunmehr gespeicherten Halbwellen ist somit ein präzises Detektieren eines Amplitudenwechsels möglich.

Bei einem denkbaren Einsatz des beschriebenen Demodulationsprinzips in kontaktlosen Chipkarten, bei denen die meßbare Amplitude eines übertragenen Signals nicht nur von der Modulation, sondern beispielsweise auch vom Abstand der Chipkarte von einer Feststation abhängen kann, kommt das Prinzip der beschriebenen Demodulation in vorteilhafter Weise zum Tragen. Denn ein Vergleich von Amplituden aufeinanderfolgender Halbwellen ermöglicht eine von der Relativposition der Chipkarte zu einer Feststation weitgehend unabhängige Auswertung, während der Vergleich zu detektierender Amplituden mit ReferenzWerten zu Fehlern führen könnte.

Das beschriebene Prinzip ist für beliebige Tastverhältnisse des Modulationssignals geeignet, da keine signifikante Entlade-Zeitkonstante gebildet wird. Denn die beschriebenen Schalter zum Entladen der ersten und zweiten Kondensatoren bilden in geschlossenem Zustand niederohmige Pfade nach Masse.

Je nach Ausführung der Auswerteeinheit kann mit beschriebener Anordnung beispielsweise entweder die Einhüllende des amplitudenmodulierten Signals abgeleitet werden oder ein vom demodulierten Signal abgeleitetes differenziertes Signal, welches Flankenwechsel anzeigt.

In der vorliegenden Erfindung ist ein Umschalter vorgesehen, welcher zwischen Diode und Kondensatoren angeordnet ist. Mit diesem Schalter ist es möglich, das zu demodulierende Signal entweder dem ersten oder dem zweiten Kondensator zuzuführen.

In einer vorteilhaften Ausführungsform der vorliegenden Erfindung sind der erste und der zweite Schalter NMOS-Transistorschalter, welche für hohe Frequenzen erforderliche Schaltzeiten aufweisen und niederohmige Pfade zum Entladen der jeweiligen Kondensatoren bilden.

In dem vorliegenden Erfindungsgemäßen Verfahren werden aufeinanderfolgende Halbwellen des gleichgerichteten, zu demodulierenden, amplitudenmodulierten Signals abwechselnd auf den ersten und zweiten Kondensator geschaltet. Die Schaltung kann jedoch auch so angesteuert werden, daß nur z.B. jede dritte Halbwelle gespeichert und verglichen wird. Dies hat für die Auswerteschaltung zusätzlich den Vorteil, daß sie für langsamere Taktraten ausgelegt werden kann.

Weitere Einzelheiten der vorliegenden Erfindung sind in den Unteransprüchen angegeben.

Die Erfindung wird nachfolgend an zwei Ausführungsbeispielen anhand der Zeichnungen näher erläutert. Es zeigen:
- Figur 1: Ein erstes Beispiel eines Amplitudendemodulators in einem Blockschaltbild,
- Figur 2: Eine erste Ausführungsform der vorliegenden Erfindung in einem Blockschaltbild,
- Figur 3: Ein zweites Beispiel eines Amplitudendemodulators in einem Blockschaltbild, und
- Figur 4: Die zeitlichen Verläufe der Eingangsspannung sowie der Kondensatorspannungen gemäß Figur 2.

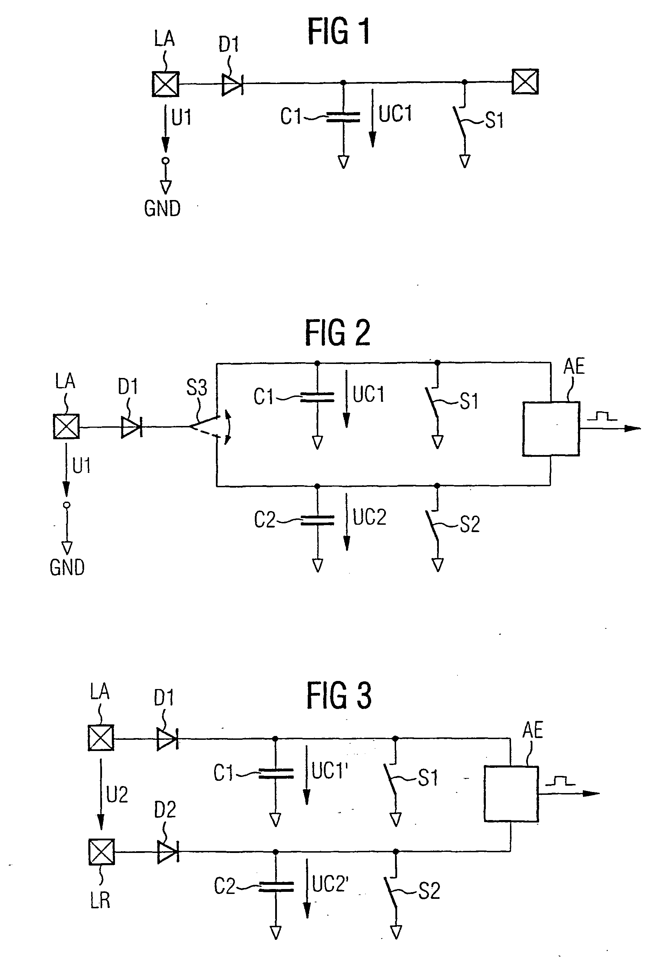

Figur 1 zeigt ein erstes Beispiel eines Amplitudendemodulators, das nicht zum Gegenstand der vorliegenden Erfindung gehört und nur zur Erklärung der Erfindung dient.

In Figur 1 ist eine Schaltungsanordnung mit einer ersten Diode D1 angegeben, der ein zu demodulierendes, amplitudenmoduliertes Signal zuführbar ist. Der Diode D1 ist ein erster Kondensator C1 gegen Masse nachgeschaltet. Eine über dem ersten Kondensator C1 anliegende Spannung ist mit UC1 bezeichnet. Parallel zum ersten Kondensator C1 ist ein Schalter S1 angeordnet.

Wird der erste Kondensator C1 mit den positiven Halbwellen des anzulegenden Signals aufgeladen, so ist jeweils der Schalter S1 geöffnet. Somit ist eine sehr lange Zeitkonstante wirksam. Während der Sperrphase der ersten Diode D1 kann der erste Kondensator C1 mit dem ersten Schalter S1 entladen werden. In diesem Schaltzustand ist eine sehr kurze Zeitkonstante wirksam. Anschließend kann der erste Kondensator C1 mit der folgenden Halbwelle wieder auf deren Spannungsmaximum aufgeladen werden. Die den Halbwellen des zu demodulierenden Signals jeweils zugeordneten, im ersten Kondensator gespeicherten Spannungswerte können in einer in Figur 1 nicht eingezeichneten Auswerteeinheit erfaßt und ausgewertet werden. Somit ist eine Demodulation des Signals möglich.

Figur 2 zeigt eine vorteilhafte Ausführungsform der vorliegenden Erfindung.

Figur 2 zeigt eine Schaltungsanordnung mit einem ersten Kondensator C1 und einem zweiten Kondensator C2. Ein zu demodulierendes, amplitudenmoduliertes Signal wird in einer den Kondensatoren vorgeschalteten ersten Diode D1 gleichgerichtet. Dabei ist das Signal der ersten Diode D1, welche im vorliegenden Beispiel in Durchlaßrichtung gepolt ist, an einem Anschluß LA zuführbar. Am Ausgang der ersten Diode D1 ist ein Umschalter S3 angeordnet. Dieser Umschalter S3 verbindet den Ausgang der Diode entweder mit einem ersten Anschluß des ersten Kondensators C1 oder mit einem ersten Anschluß des zweiten Kondensators C2. Der jeweils zweite Anschluß der Kondensatoren C1, C2 ist mit Masse verbunden. Die Spannung über dem ersten Kondensator ist mit UC1, die Spannung über dem zweiten Kondensator mit UC2 bezeichnet. Parallel zum ersten Kondensator ist ein erster Schalter S1 angeordnet. Parallel zum zweiten Kondensator ist ein zweiter Schalter S2 angeordnet. Das Eingangssignal U1, welches zu demodulieren ist, weist eine Spannung U1 gegen Masse auf. Gemäß der Verschaltung der ersten Diode D1 werden den Kondensatoren C1, C2 lediglich positive Spannungen zugeführt. Den Kondensatoren C1, C2 ist eine Auswerteeinheit AE zum Vergleich der Kondensatorspannungen UC1, UC2 nachgeschaltet. An der Auswerteeinheit AE ist ein demodüliertes Signal ableitbar.

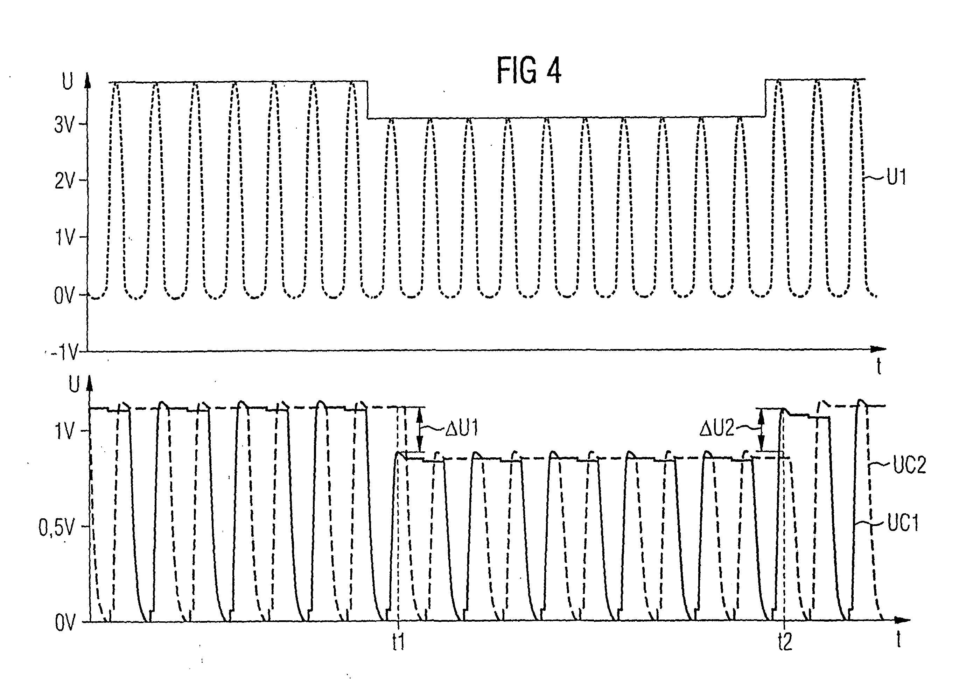

Die Funktion der Schaltung gemäß Figur 2 wird durch Hinzuziehen der in Figur 4 dargestellten, zeitlichen Verläufe der Eingangsspannung U1, sowie der Kondensatorspannungen UC1, UC2 deutlicher. Die obere Teilfigur der Figur 4 zeigt den zeitlichen Verlauf des gleichgerichteten Eingangssignals U1. Man erkennt, daß die Amplitude der Halbwellen zwei verschiedene Werte annehmen kann, wie bei einer digitalen Modulation üblich. Dabei kann ein Amplitudenwert einen ersten, und ein vom ersten Amplitudenwert verschiedener, zweiter Amplitudenwert einen zweiten logischen Zustand repräsentieren. Die den eigentlichen Informationsgehalt aufweisende, amplitudenmodulierte Rechteckfunktion ist über dem Spannungsverlauf des zu demodulierenden Signals mit der Spannung U1 angedeutet. In einer im unteren Teil von Figur 4 dargestellten Teilzeichnung sind die zeitlichen Verläufe der Kondensatorspannungen angegeben. Dabei bezeichnet UC1 den Spannungsverlauf an einem ersten Kondensator und UC2 den Spannungsverlauf an einem zweiten Kondensator. Man erkennt, daß mit der ersten Halbwelle der Eingangsspannung U1 der zweite Kondensator C2 aufgeladen wird. Während der zweite Kondensator noch auf seinen Maximalwert aufgeladen ist, wird mit der zweiten Halbwelle der erste Kondensator C1 aufgeladen. Nunmehr ist ein Vergleich der Spannungen am ersten und zweiten Kondensator möglich. Da diese jedoch keine signifikante Abweichung voneinander aufweisen, wird kein Wechsel des Signalpegels detektiert. Nunmehr wird nach Vergleich der Kondensatorspannungen der zweite Kondensator C2 durch Schließen des Schalters S2 entladen und anschließend mit der dritten Halbwelle des Eingangssignals mit der Spannung U1 wieder auf den Maximalwert aufgeladen. Nunmehr kann die zweite mit der dritten Halbwelle verglichen werden. Auch hier ist jedoch keine Amplitudenänderung detektierbar. In der Folge werden die Kondensatoren C1, C2 abwechselnd mit Halbwellen der Eingangsspannung U1 aufgeladen. Ein Vergleich der ersten mit der zweiten Kondensatorspannung zum Zeitpunkt T1 zeigt eine Amplitudendifferenz ΔU1. Folglich hat sich der Zustand des Modulationssignals von High auf Low geändert. Zum Zeitpunkt T2 liegt ebenfalls ein Wechsel des Signalpegels vor. Dieser wird durch die Spannungsdifferenz ΔU2 zwischen Kondensatorspannung des ersten und zweiten Kondensators repräsentiert, deren Spannungsdifferenz zum Zeitpunkt T2 gebildet wird. Der Vergleich der Kondensatorspannungen UC1, UC2 erfolgt in einer Auswerteeinheit AE. An der Auswerteeinheit AE ist ein demoduliertes Signal ableitbar.

Die Kondensatoren C1 und C2 werden also abwechselnd auf den Maximalwert der Spannung U1, abzüglich der an der ersten Diode D1 abfallenden Spannung, aufgeladen. Die Spannung an einem Kondensator C1, C2 muß jeweils so lange gehalten werden, bis der jeweils andere Kondensator C2, C1 mit der nachfolgenden Halbwelle des Eingangssignals aufgeladen ist. Bevor anschließend einer oder beide Kondensatoren mittels den Schaltern S1, S2 entladen wird, wird die Spannung UC1, UC2, welche am ersten Kondensator C1 beziehungsweise am zweiten Kondensator C2 anliegt, in einer Auswerteeinheit AE verglichen, um eine eventuell aufgetretene Änderung der Amplitude des modulierten Signals zu detektieren. Die Ansteuerung der Schalter S1, S2, S3 ist in der Schaltung gemäß Figur 2 nicht eingezeichnet. Dem Signalverlauf der Spannungen gemäß Figur 4 ist eine geeignete Ansteuerung der Schalter jedoch leicht zu entnehmen.

Für den Fall, daß das zu demodulierende, amplitudenmodulierte Signal als Differenzsignal vorliegt, ist eine daran angepaßte Schaltungsanordnung in einem prinzipiellen Blockschaltbild in Figur 3 angegeben. Die Schaltungsanordnung von Figur 3 gehört jedoch nicht zum Gegenstand der vorliegenden Erfindung und dient hier nur zur Erklärung. Das Paar von differentiellen Signalen mit der Spannung U2 ist dabei dem Klemmenpaar LA, LB zuführbar. Die Klemme LA ist ein erster Anschluß einer ersten Diode D1, deren Ausgang mit einem ersten Kondensator C1 verbunden ist. Parallel zum ersten Kondensator C1 ist ein erster Schalter S gegen Masse geschaltet. Eine über dem ersten Kondensator anliegende Spannung ist mit UC1' bezeichnet. An einem zweiten Klemmenanschluß LB ist eine zweite Diode D2 angeschlossen. Der zweiten Diode D2 ist ein zweiter Kondensator C2 nachgeschaltet, welcher mit einem seiner Anschlüsse mit Masse verbunden ist. Parallel zum zweiten Kondensator ist ein zweiter Schalter S2 angeordnet. Über dem zweiten Kondensator C2 ist eine Spannung UC2' abgreifbar. Die Schaltung gemäß Figur 3 erfordert keinen Umschalter S3, da hier eine differentielle Eingangsspannung, welche eine hochfrequente amplitudenmodulierte Spannung ist, anliegt. Der Vergleich der Kondensatorspannungen UC1, UC2 erfolgt in einer Auswerteeinheit AE, an der ein demoduliertes Signal abgreifbar ist.

Das funktionale Grundprinzip der Schaltung gemäß Figur 3 entspricht der Schaltung gemäß Figur 2. Die Ansteuerung des ersten und zweiten Schalters S1, S2 der Schaltung gemäß Figur 3 erfolgt gemäß dem bei Figur 2 beschriebenen Prinzip: Die Halbwellen des anliegenden Differenzsignals werden abwechselnd in den Kondensatoren C1, C2 gespeichert und die in den Kondensatoren C1, C2 in Form eines Spannungswertes gespeicherten Amplituden der jeweiligen Halbwellen werden miteinander verglichen. Dabei können wiederum jeweils unmittelbar aufeinanderfolgende Halbwellen miteinander verglichen werden oder jeweils jede 2. oder 3. etc. Halbwelle gespeichert und verglichen werden. Der Vergleich der Amplitudenwerte ermöglicht eine Demodulierung des amplitudenmodulierten Signals.

Die beschriebene erfindungsgemäße Ausführungsform ermöglicht eine einfache und präzise Demodulation eines amplitudenmodulierten Signals. Für die zur Realisierung des beschriebenen Demodulationsprinzips erforderlichen Schaltungen ist lediglich eine sehr geringe Anzahl von Bauteilen erforderlich. Somit können derartige Schaltungen mit geringem Aufwand realisiert werden. Da die Entladung der Kondensatoren mittels Schaltern, und nicht mit zu Ladezeitkonstanten führenden Widerständen erfolgt, ist das beschriebenen Prinzip auch bei hohen Frequenzen anwendbar.

## Patentansprüche

1. Amplituden-Demodulationsschaltung, aufweisend
- einen Schaltungseingang (LA), dem ein amplitudenmoduliertes Signal zuführbar ist,
- einen ersten Kondensator (C1), dem ein vom amplitudenmodulierten Signal abgeleitetes Signal zuführbar ist, über dem eine Spannung (UC1) abgreifbar ist, und der mit einem Anschluß nach Masse (GND) geschaltet ist,
- eine erste Entladevorrichtung (S1), welche parallel zu dem ersten Kondensator (C1) geschaltet ist,
- einen zweiten Kondensator (C2), dem ein vom amplitudenmodulierten Signal abgeleitetes Signal zuführbar ist, über dem eine Spannung (UC2) abgreifbar ist und der mit einem Anschluß nach Masse (GND) geschaltet ist,
- eine zweite Entladevorrichtung (S2) welche parallel zu dem zweiten Kondensator (C2) geschaltet ist,
- ein Mittel zur Gleichrichtung des amplitudenmodulierten Signals und zum abwechselnden Speichern von Amplitudenwerten aufeinanderfolgender Halbwellen des gleichgerichteten amplitudenmodulierten Signals (D1, S3) auf den Kondensatoren (C1, C2), das diese mit dem Signaleingang (LA) koppelt und
- eine Auswerteeinheit (AE) zum Vergleich der Spannungen (UC1, UC2) am ersten und zweiten Kondensator (C1, C2), an welcher ein amplitudendemoduliertes, vom amplitudenmodulierten Signal abgeleitetes Signal abgreifbar ist, wobei das Mittel eine Diode (D1) und einen Schalter (S3) umfasst, wobei der Schalter (S3) zwischen der Diode (D1) und den Kondensatoren (C1, C2) angeordnet ist und in einer ersten Schalterstellung die Diode (D1) mit einem Anschluß des ersten Kondensators (C1) und in einer zweiten Schalterstellung die Diode (D1) mit einem Anschluß des zweiten Kondensators (C2) verbindet.

2. Amplituden-Demodulationsschaltung nach Anspruch 1,
**dadurch gekennzeichnet, daß**
die erste und die zweite Entladevorrichtung (Sl, S2) NMOS-Transistorschalter sind.

3. Verfahren zur Demodulation eines amplitudenmodulierten Signals mit folgenden Verfahrensschritten:
- Zuführen des Signals an eine Diode (D1),
- Gleichrichten des Signals mit der Diode (D1),
- Aufladen eines ersten Kondensators (C1) mit einer ersten Halbwelle des gleichgerichteten Signals auf eine erste Kondensatorspannung (UC1),
- Aufladen eines zweiten Kondensators (C2) mit einer zweiten Halbwelle des gleichgerichteten Signals auf eine zweite Kondensatorspannung (UC2),
- Vergleich der ersten und zweiten Kondensatorspannung (UC1, UC2) und Detektieren einer auftretenden Amplitudenänderung (ΔU1, ΔU2),
- Entladen des ersten Kondensators (C1), und
- Entladen des zweiten Kondensators (C2), wobei
- unmittelbar aufeinanderfolgende Halbwellen des gleichgerichteten Signals abwechselnd auf den ersten Kondensator (C1) und den zweiten Kondensator (C2) geschaltet werden.

## Claims

1. Amplitude demodulation circuit, having
- a circuit input (LA) to which an amplitude-modulated signal can be supplied,
- a first capacitor (C1), to which a signal which is derived from the amplitude-modulated signal can be supplied and across which a voltage (UC1) can be tapped off, and one connection of which is connected to ground (GND),
- a first discharging apparatus (S1) which is connected in parallel with the first capacitor (C1),
- a second capacitor (C2), to which a signal which is derived from the amplitude-modulated signal can be supplied and across which a voltage (UC2) can be tapped off, and one connection of which is connected to ground (GND),
- a second discharging apparatus (S2) which is connected in parallel with the second capacitor (C2),
- a means for rectifying the amplitude-modulated signal and for alternate storage of amplitude values of successive half-cycles of the rectified amplitude-modulated signal (D1, S3) on the capacitors (C1, C2), which means couples them to the signal input (LA), and
- an evaluation unit (AE) for comparison of the voltages (UC1, UC2) across the first and second capacitors (C1, C2) and on which an amplitude-demodulated signal which is derived from the amplitude-modulated signal can be tapped off, the means comprising a diode (D1) and a switch (S3), the switch (S3) being arranged between the diode (D1) and the capacitors (C1, C2) and connecting the diode (D1) to a connection of the first capacitor (C1) in a first switch position, and connecting the diode (D1) to a connection of the second capacitor (C2) in a second switch position.

2. Amplitude demodulation circuit according to Claims 1,
**characterized in that**
the first and the second discharging apparatuses (S1, S2) are NMOS transistor switches.

3. Method for demodulation of an amplitude-modulated signal having the following method steps:
- the signal is supplied to a diode (D1),
- the signal is rectified using the diode (D1),
- a first capacitor (C1) is charged with a first half-cycle of the rectified signal to a first capacitor voltage (UC1),
- a second capacitor (C2) is charged with a second half-cycle of the rectified signal to a second capacitor voltage (UC2),
- the first and second capacitor voltages (UC1, UC2) are compared, and any amplitude change (ΔU1, ΔU2) which occurs is detected,
- the first capacitor (C1) is discharged, and
- the second capacitor (C2) is discharged, wherein
- immediately successive half-cycles of the rectified signal being connected alternately to the first capacitor (C1) and to the second capacitor (C2).

## Revendications

1. Circuit de démodulation en amplitude comprenant :
- une entrée ( LA ) de circuit à laquelle peut être envoyé un signal modulé en amplitude ;
- un premier condensateur ( C1 ), auquel peut être envoyé un signal dérivé du signal modulé en amplitude, aux bornes duquel peut être prélevée une tension ( UC1 ) et qui est mis à la masse ( GND ) par une borne ;
- un premier dispositif ( S1 ) de décharge qui est monté en parallèle au premier condensateur ( C1 ) ;
- un deuxième condensateur ( C2 ), auquel peut être envoyé un signal dérivé du signal modulé en amplitude, aux bornes duquel une tension ( UC2 ) peut être prélevée et qui est mis à la masse ( GND ) par une borne ;
- un deuxième dispositif ( S2 ) de décharge qui est monté en parallèle au deuxième condensateur ( C2 ) ;
- un moyen de redressement du signal modulé en amplitude et d'accumulation en alternance de valeurs d'amplitude de demi-ondes successives du signal ( D1, S3 ) redressé modulé en amplitude sur les condensateurs ( C1, C2 ), moyen qui couple ceux-ci à l'entrée ( LA ) du signal ; et
- une unité ( AE ) d'exploitation pour comparer les tensions ( UC1, UC2 ) sur le premier et le deuxième condensateurs ( C1, C2 ) sur lesquels un signal modulé en amplitude et dérivé du signal modulé en amplitude peut être prélevé, le moyen comprenant une diode ( D1 ) et un commutateur ( S3 ), le commutateur ( S3 ) étant monté entre la diode ( D1 ) et les condensateurs ( C1, C2 ) et reliant dans une première position du commutateur la diode ( D1 ) à une borne du premier condensateur ( C1 ) et dans une deuxième position du commutateur la diode ( D1 ) à une borne du deuxième condensateur ( C2 ).

2. Circuit de démodulation d'amplitude suivant la revendication 1, **caractérisé en ce que** le premier et le deuxième dispositifs ( S1, S2 ) de décharge sont des commutateurs à transistor NMOS.

3. Procédé de démodulation d'un signal modulé en amplitude comprenant des stades de procédé suivants :
- envoi du signal à une diode ( D1 ) ;
- redressement du signal par la diode ( D1 ) ;
- charge d'un premier condensateur ( C1 ) par une première demi-onde du signal redressé jusqu'à une première tension ( UC1 ) de condensateur ;
- charge d'un deuxième condensateur ( C2 ) par une deuxième demi-onde du signal redressé jusqu'à une deuxième tension ( UC2 ) de condensateur ;
- comparaison de la première et de la deuxième tensions ( UC1, UC2 ) de condensateur et détection d'une variation ( ΔU1, ΔU2 ) d'amplitude qui se produit ;
- décharge du premier condensateur ( C1 ) ; et
- décharge du deuxième condensateur ( C2 ), dans lequel
- des demi-ondes se succédant directement du signal redressé sont appliquées alternativement au premier condensateur ( C1 ) et au deuxième condensateur ( C2 ).
